(19) Europäisches Patentamt / European Patent Office / Office européen des brevets

(11) **EP 1 766 695 B1**

(12) **EUROPÄISCHE PATENTSCHRIFT**

(45) Veröffentlichungstag und Bekanntmachung des Hinweises auf die Patenterteilung:
**11.07.2012  Patentblatt 2012/28**

(21) Anmeldenummer: 05751006.7

(22) Anmeldetag: **25.05.2005**

(51) Int Cl.:
**H01L 33/54** (2010.01)      **H01L 33/58** (2010.01)
**H01L 33/60** (2010.01)

(86) Internationale Anmeldenummer:
**PCT/EP2005/005681**

(87) Internationale Veröffentlichungsnummer:
**WO 2006/005393 (19.01.2006 Gazette 2006/03)**

(54) **WEISSER LED-STRAHLER MIT KEGELFOERMIGEM REFLEKTOR UND PLANAREN FACETTEN**

WHITE LED SPOTLIGHT HAVING A FUNNEL-SHAPED REFLECTOR AND PLANAR FACETS

SPOT A DEL BLANCHE AVEC UN RÉFLECTEUR EN FORME D'ENTONNOIR ET FACETTES PLANES

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **14.07.2004  DE 202004011015 U**

(43) Veröffentlichungstag der Anmeldung:
**28.03.2007  Patentblatt 2007/13**

(60) Teilanmeldung:
**10185807.4 / 2 264 796**

(73) Patentinhaber: Tridonic Jennersdorf GmbH
**8380 Jennersdorf (AT)**

(72) Erfinder:
• **HOSCHOPF, Hans**
  **A-8380 Jennersdorf (AT)**
• **TASCH, Stefan**
  **A-8380 Jennersdorf (AT)**
• **PACHLER, Peter**
  **A-8042 Graz- St. Peter (AT)**

(74) Vertreter: **Rupp, Christian et al**
**Mitscherlich & Partner**
**Patent- und Rechtsanwälte**
**Sonnenstraße 33**
**80331 München (DE)**

(56) Entgegenhaltungen:
**EP-A- 1 418 628    EP-A- 1 427 029**
**WO-A-02/50472    US-A- 1 726 379**
**US-A- 3 875 456    US-A- 4 009 394**
**US-A- 4 143 394    US-A1- 2002 185 966**

• **PATENT ABSTRACTS OF JAPAN Bd. 008, Nr. 049 (E-230), 6. März 1984 (1984-03-06) -& JP 58 204575 A (MITSUBISHI RAYON KK), 29. November 1983 (1983-11-29)**
• **SCHLOTTER P ET AL: "Fabrication and characterization of GaN/InGaN/AlGaN double heterostructure LEDs and their application in luminescence conversion LEDs" MATERIALS SCIENCE AND ENGINEERING B, ELSEVIER SEQUOIA, LAUSANNE, CH, Bd. 59, Nr. 1-3, 6. Mai 1999 (1999-05-06), Seiten 390-394, XP004173273 ISSN: 0921-5107**

**Beschreibung**

Die vorliegende Erfindung bezieht sich auf LED-Strahler.

Der Hintergrund der vorliegenden Erfindung ist das Gebiet der Leuchtdioden und insbesondere das Gebiet der 'weißen' Leuchtdioden (LEDs). Gemäß dem Stand der Technik wird zum Erzeugen von weißem Licht mittels Leuchtdioden farbiges, insbesondere blaues Licht mittels Farbkonversion oder mittels Mischung von Lichtanteilen von verschiedenfarbigen LEDs erzeugt. Beispielsweise kann das weiße Licht durch Mischung von von einem LED-Chip erzeugten blauen Licht mit gelbem Licht entstehen, welches beim Durchtritt des blauen Lichts durch ein die LEDs umgebendes Farbkonversionsmaterial aus einem Teil des blauen Lichts erzeugt wird.

Aufgrund der Eigenschaften der Farbkonversionsmaterialien und den technischen Einschränkungen bei der Fertigung der LEDs entstehen dabei oft unterschiedlich gefärbte Bereiche der über den LEDs angeordneten Farbkonversionsschicht, welche durch Abbildung derselben zu einem inhomogenen Farbverteilung führen. Dies ist insbesondere bei konventionellen Brechungslinsen der Fall. Bei brechenden Linsen ergibt sich insbesondere bei engstrahligen LEDs die Schwierigkeit, das blaue Licht mit dem gelben konvertierten Licht über den gesamten Abstrahlungsbereich derart zu vermischen, dass homogenes weißes licht abgestrahlt wird.

Bei der Erzeugung von weißem Licht ausgehend von blauen LEDs ist es schwierig, die blaue Farbe mit der gelben konvertierten Farbe über die gesamte Abstrahlbreite derart zu vermischen, dass homogenes weißes Licht abgestrahlt wird.

Aus der WO 02/50472 A1 ist eine LED-Strahleranordnung mit einem Innen offenen Reflektor bekannt. Da am Boden des Reflektors verschiedenfarbige LEDs angeordnet sind, ist keine Farbkonversion notwendig.

Die EP 1 418 628 A1 zeigt eine LED Anordnung mit einem LED-Modul, welches in einer Ausnehmung eines Trägers vorgesehen ist. Vor dem LED-Modul und von dem LED-Modul und dem Träger beabstandet ist ein optisches Element mit einem dem LED-Modul zugewandten Leuchtstoffmaterial vorgesehen. Um den Verlust von auf die Mantelfläche des optischen Elements auftreffenden Lichtstrahlen des LED-Moduls zu vermeiden, ist die Mantelfläche vorzugsweise reflektierend ausgebildet.

Die US 4,143,394 zeigt eine LED in einem Gehäuse. Das Gehäuse weist eine im Wesentlichen quaderförmige bzw. zylinderförmige Form mit parallelen Seitenwänden auf. In einem Bereich ab der Höhe der LED und einem darüber liegenden Teilbereich des Gehäuses sind die Seitenwände des Gehäuses abgewinkelt. In diesem abgewinkelten Bereich wird Licht, welches seitlich von der LED austritt, zu einer Lichtabstrahlfläche reflektiert. Eine Streuscheibe ist außerhalb des Gehäuses auf der Abstrahlfläche vorgesehen.

Die US 1,726,379 zeigt einen Reflektor gebildet aus zahlreichen kleinen Spiegeln zur Bereitstellung einer gerichteten Lichtausstrahlung mehrerer Lichtquellen.

Aufgabe der vorliegenden Erfindung ist es, die Abstrahleigenschaften von LED-Strahlern zu verbessern.

Diese Aufgabe wird erfindungsgemäß durch die Merkmale des unabhängigen Anspruchs gelöst. Die abhängigen Ansprüche bilden den zentralen Gedanken der Erfindung in besonders vorteilhafter Weise weiter.

Gemäß einem ersten Aspekt der vorliegenden Erfindung ist also ein Weißlicht-LED-Strahler vorgesehen, der eine Anordnung mit wenigstens einer farbigen LED, über der ein Farbkonversionsstoff angeordnet ist, der das Licht der LED konvertiert, sowie eine über dem Farbkonversionsstoff angeordnete Kegeloptik aus einem im wesentlichen transparentem Vollmaterial aufweist, die sich vorzugsweise von der LED-Anordnung weg erweitert. Die LED-Anordnung ist bezüglich der Kegeloptik derart angeordnet, dass ein Teil des Lichts von der LED-Anordnung direkt auf die Mantelfläche der Kegeloptik trifft und von dort durch Totalreflexion in Richtung einer Austrittsfläche der Kegeloptik gelenkt wird, während ein anderer Teil des Lichts von der LED-Anordnung ohne Reflexion an der Mantelfläche der Kegeloptik direkt zu der Austrittsfläche gelangt, wobei an der Austrittsfläche Weißlicht durch Mischung des Lichts von der LED mit dem durch Farbkonversion erzeugten Licht austritt, wobei der Winkel, den die Mantelfläche mit der Symmetrieachse bildet, ein spitzer Winkel ist und mit zunehmendem Abstand von der LED-Anordnung flacher wird. Somit mischt sich "indirektes" Licht, d.h. Licht, das an der Seitenfläche (Grenzschicht zur umgebenden Luft) der Kegeloptik totalreflektiert wurde, mit dem Lichtanteil, der ohne Reflektion "direkt" das Kegeloptikmaterial hin zur Austrittsfläche durchläuft.

Die Basisfläche der Kegeloptik weist die Form eines Polygons auf. Die Außenwand der Kegeloptik weist wenigstens in Teilbereichen planare Facetten auf. Die Außenwand der Kegeloptik weist drei Kreisbogenbereiche auf, die jeweils aus bezüglich der Symmetrieachse der Kegeloptik geneigten planaren Facetten bestehen, wobei der dem Farbkonversionsstoff zugewandte Kreisbogen der planaren Facetten Lichtstrahlen von einer angenommenen Punktlichtquelle im Zentrum der LED-Chip-Oberfläche in einem Winkelbereich von 55°-75° bezüglich der Symmetrieachse der Kegeloptik zur Austrittsfläche derart totalreflektiert, dass sie eine Totalreflexion an der Innenseite der Kegeloptik von 5°-0° zur Symmetrieachse der Kegeloptik erfahren, wobei sich an den ersten Kreisbogen der zweiter Kreisbogen anschließt, welcher sich ausgehend vom ersten Kreisbogen von dem Farbkonversionsstoff weg erstreckt, wobei der zweite Kreisbogen Lichtstrahlen von der angenommenen Punktlichtquelle im Zentrum der LED-Chip-Oberfläche in einem Winkelbereich von 40-55° bezüglich der Symmetrieachse der Kegeloptik zur Austrittsfläche derart totalreflektiert, dass sie eine Totalreflexion an der Innenseite der Kegeloptik von 0°-5° zur Symmetrieachse der Kegeloptik erfahren, wobei sich an den zweiten Kreisbogen der dritte Kreisbogen anschließt, welcher sich ausgehend vom zweiten Kreisbogen von dem Farbkonversionsstoff weg erstreckt, wobei der dritte Kreisbogen Lichtstrahlen von einer angenommenen Punktlichtquelle im Zentrum der LED-Chip-Oberfläche in einen Winkelbereich von 28-40° bezüglich der Symmetrieachse der Kegeloptik zur Austrittsfläche derart totalreflektiert, dass sie eine Totalreflexion an der Innenseite der Kegeloptik von 5°-0° zur Symmetrieachse der Kegeloptik erfahren, und wobei Lichtstrahlen von einer angenommenen Punktlichtquelle im Zentrum der LED-Chip-Oberfläche in einen Winkelbereich von 0-28° bezüglich der Symmetrieachse der Kegeloptik ohne Reflexion an der Mantelfläche der Kegeloptik direkt zu der Austrittsfläche gelangen.

Oberhalb der LED-Anordnung, d.h. zwischen der LED-Anordnung und der Austrittsfläche, ist ein Farbkonversionsmaterial angeordnet. Das Farbkonversionsmaterial kann dabei insbesondere in Form eines Quaders angeordnet werden.

Im Falle von mehreren LEDs können diese gleichfarbig oder auch verschiedenfarbig sein.

Die LED-Anordnung kann bündig in einen Träger eingesetzt sein, der mit der Basisebene der Kegeloptik abschließt.

Weitere Vorteile, Merkmale und Eigenschaften der vorliegenden Erfindung sollen nunmehr Bezug nehmend auf die Figuren der begleitenden Zeichnungen näher erläutert werden.

Fig. 1     zeigt dabei eine schematische Ansicht des Strahlengangs in einer erfindungsgemäßen Kegeloptik,

Fig. 2     zeigt eine perspektivische Ansicht einer trichterförmigen kegeloptik gemäß der vorliegenden Kegeloptik Erfindung,

Fig. 3     zeigt eine schematische Schnittansicht eines Ausführungsbeispiels eines erfindungsgemäßen LED-Strahlers mit eingesetztem LED-Chip

Fig. 4     zeigt eine weitere Ausführungsform eines erfindungsgemäßen LED-Strahlers, und

Fig. 5     zeigt eine teilverspiegelte Kegeloptik.

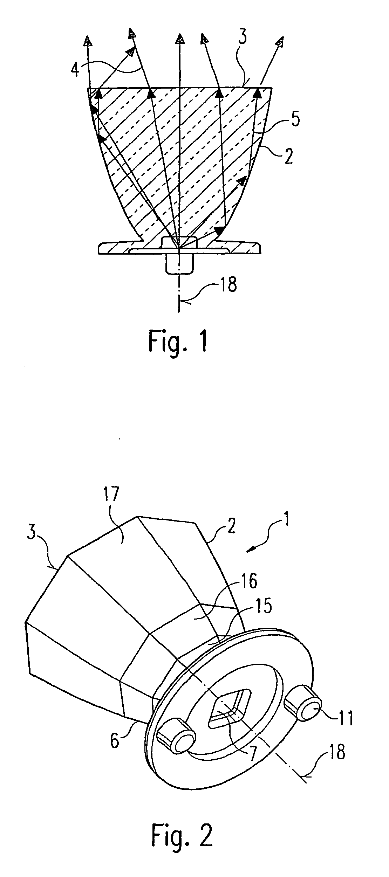

Wie in Fig. 1 ersichtlich ist gemäß der vorliegenden Erfindung für einen LED-Strahler eine trichterförmige Linse in Form einer Kegeloptik 1 aus im wesentlichen transparentem Wollmaterial vorgesehen, die Seitenwände 2 sowie eine Austrittsfläche 3 aufweist, die senkrecht zur Symmetrieachse der Kegeloptik 1 steht. Das Material der Kegeloptik kann bspw. einen Brechungsindex von 1,4 bis 1,6, insbesondere 1,50 bis 1,55 aufweisen.

An der Grenzschicht von der Kegeloptik zu der umgebenden Luft wird von Innen auftreffendes Licht totalreflektiert, so dass es an den Seitenwänden der Kegeloptik nicht austritt. Da es dagegen auf die Austrittsfläche der Kegeloptik in einem wesentlichen steileren Winkel auftritt, wird es dort nicht reflektiert, sondern lediglich von der Normalen der Austrittsfläche weggebrochen.

Durch den spitzen Winkel, den die Mantelfläche der Kegeloptik zu der Symmetrieachse einschliesst, ist sichergestellt, dass das Licht von der LED-Anordnung in einem Winkel auftrifft, der kleiner oder gleich dem Grenzwinkel für die Totalreflektion ist. Da dieser Grenzwinkel $\alpha$ gemäss der folgenden Gleichung

$$\sin(\alpha) \ = \ n1/n2$$

ein Funktion des Brechungsindexes n2 des Materials der Kegeloptik (und des Brechungsindexes n1 der umgebenden Luft) ist, hängt der mögliche Verlauf der Mantelfläche der Kegeloptik von dem Brechungsindex des für die Kegeloptik gewählten Materials ab.

Vorteilhaft ist es indessen, wenn der Winkel, den die Mantelfläche zu der Symmetrieachse bildet, mit zunehmendem Abstand von der LED-Lichtquelle flacher wird.

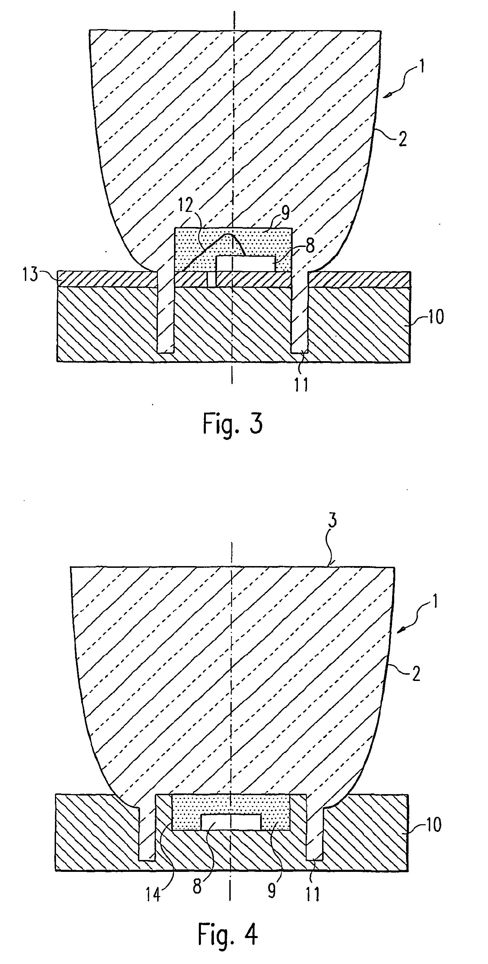

In dem Bereich mit geringerem Querschnitt der Kegeloptik 1 ist als LED-Lichtquelle beispielsweise ein LED-Chip vorgesehen, der in Figuren 3 und 4 dargestellt ist und später bezugnehmend auf diese Figuren erläutert werden wird. Der LED-Chip weist eine LED-Anordnung mit einer oder mehreren LEDs auf.

Von diesem LED-Chip kann Licht 4 direkt in Richtung der Austrittsfläche 3 strahlen.

Indirektes Licht, das dagegen auf die Grenzfläche der Kegeloptik 1 trifft, wird dort aufgrund der entsprechend gewählten Brechungseigenschaften und des Auftrittswinkels totalreflektiert und somit in den Bereich der Austrittsfläche 3 gelenkt.

Wie in Fig. 2 ersichtlich, weist die Seitenwand 2 der Kegeloptik 1 zumindest teilweise planare Facetten 6 auf.

Im unteren Bereich der Kegeloptik 1 ist eine Öffnung zum Einsetzen eines LED-Chips vorgesehen. Weiterhin kann die Unterseite der Kegeloptik 1 Befestigungsansätze 11 aufweisen, mittels derer die Kegeloptik 1 auf einem Träger positioniert und ggf. montiert werden kann.

Der LED-Strahler ist durch das Material der Kegeloptik, den Farbkonversionsstoff und die LED-Lichtquelle vollständig, d.h. ohne hohle Bereiche oder Lufteinschlüsse ausgefüllt.

In dem Ausführungsbeispiel von Fig. 3 ist die Kegeloptik 1 mittels den Befestigungsansätzen 11 in einen Träger 10 eingesetzt und positioniert. Auf der Oberseite des Trägers 10 ist eine Leiterplatte 13 vorgesehen. Im Inneren der Kegeloptik 1 ist ein LED-Chip 8 angeordnet, der gegenüber der Leiterplatte 13 an seiner Unterseite isoliert ist, aber beispielsweise mittels Bonddrähten 12 entsprechend mit dieser elektrisch kontaktiert ist. Oberhalb des LED-Chips 8 ist in Form eines Quaders Farbkonversionsmaterial 9 aufgebracht.

Das Ausführungsbeispiel von Fig. 4 unterscheidet sich von demjenigen von Fig. 3 dadurch, dass der LED-Chip 8 sowie das Farbkonversionsmaterial 9, wiederum in Form eines Quaders, in eine Vertiefung 14 in den Träger 10 bündig abschließend eingesetzt ist.

Gemäß der Erfindung wird also die Durchmischung von der Lichtfarbe, die der Ausstrahlfarbe des LED-Chips 8 entspricht, mit der Lichtfarbe, die durch die Konversion im Farbkonvertiermaterial 9 entsteht, entscheidend verbessert. Dabei erfolgt die Verbesserung der Vermischung insbesondere durch wenigstens eine der folgenden Mechanismen:

- Es wird eine Kegeloptik 1 verwendet, bei der Licht aus den seitlichen Totalreflexionsbereichen und das direkt über die ebene Deckfläche emittierte Licht überlagert wird. Dadurch wird über eine geeignete Abbildung der seitlichen Kegelwände 2 eine erste Durchmischung des Lichts erreicht.

- Die Durchmischung kann weiter verbessert werden, wenn der Kegel in mehrere Segmente unterteilt wird, welches jedes für sich bereits die gewünschte Abstrahlung generiert. Durch die Überlagerung der Abstrahlung der einzelnen Kegelbereiche (s. beispielsweise die Facetten 6 in Fig. 2) wird eine weitere Durchmischung des Lichts erreicht. Der 'Kegel' weist in diesem Fall eine polygone Basisfläche auf.

- Durch zusätzlich angebrachte Facetten 6 wird eine weitere Verbesserung der Durchmischung des Lichts erreicht; diese führt aber nur Durchmischung in den kleineren Raumwinkelbereichen durch. Weiter unten werden die Winkellagen dieser Facetten weiter spezifiziert.

- Durch die Anpassung der Geometrie des Farbkonvertierungsmaterials wird ebenfalls dafür gesorgt, dass die Emission des Lichtes in den verschiedenen Bereichen so gering wie möglich variiert. Weiterhin bleibt dadurch die Oberflächenfarbe des Farbkonvertierungsmaterials in den technisch möglichen Grenzen gleichartig.

Hinsichtlich der Winkellage der Facetten in der Kegeloptik sind die folgenden Bereiche vorteilhaft:

1. Lichtstrahlen von einer angenommenen Punktlichtquelle im Zentrum der Chip-Oberfläche werden in einem Winkelbereich von 0 bis 28° (im Material) direkt nach außen, d.h. zur Abstrahlfläche 3 ausgesandt.

2. In einem Winkelbereich von 28 bis 40° erfahren sie eine Totalreflexion an der Innenseite der Kegeloptik 1 von 5° zur Symmetrieachse der Kegeloptik bis zu 0°.

3. In einem Austrittsbereich von 40 bis 55° erfahren sie eine Totalreflexion von 0° bis 5° zur Symmetrieachse und von 55° bis 75° erfahren sie eine Totalreflexion von 5° zur Achse bis 0°.

Die Überlagerung der Abstrahlungen aus diesen unterschiedlichen Bereichen ergibt somit die homogene Vermischung. Die drei angesprochenen Zonen lassen sich in der Kegeloptik 1 durch Seitenwände 2 mit Kreisbögen bspw. mit tangentialem Übergang ausbilden, wie es schematisch in Fig. 2 dargestellt ist. Anstelle des tangentialen Übergangs kann indessen auch eine Kante vorliegen.

Mit 15 ist dabei der Kreisbogen der planaren Facetten bezeichnet, der die Lichtstrahlen mit dem Austrittsbereich von 55° bis 75° totalreflektiert. Mit 16 ist der Kreisbogen der planaren Facetten bezeichnet, der Licht mit dem Austrittswinkel von 40° bis 55° totalreflektiert. Schließlich ist mit 17 der Kreisbogen der planaren Facetten bezeichnet, der Licht im Bereich von 28 bis 40° totalreflektiert. Wie gesagt, Licht von einem Austrittswinkel von 0 bis 28°, stets gemessen zur Symmetrieachse 18, tritt direkt in der Austrittsfläche 3 aus.

Die in Figuren 3 und 4 dargestellte Quaderform des Farbkonversionsmaterials ermöglicht eine relativ geringe Farbvarianz an der Oberfläche des Farbkonversionsmaterials. Eine genaue relative Positionierung des LED-Chips, des Farbkonversionsmittels sowie der Kegeloptik kann dadurch erleichtert werden, dass die Kontur des Farbkonversionsmaterial formmäßig durch die Unterseite der Kegeloptik definiert ist.

Die Kegeloptik kann mit dem LED-Träger 10 in verschiedenster Weise befestigt werden. Beispielsweise kann der LED-Chip in die Kegeloptik eingebracht werden. Die Kegeloptik kann entweder in dem Träger wie in Fig. 4 gezeigt eingesetzt werden und/oder angeklebt bzw. ultraschallverschweißt werden. Alternativ dazu kann die Kegeloptik auch derart an der Basis verbreitert sein, dass sie direkt auf den Träger aufgesetzt werden kann (s. Figuren 2 und 4). In letzterem Fall kann die Positionierung bevorzugt durch die dargestellten 'Beinchen' 11 erfolgen, mit welchen die Kegeloptik in Bohrungen (s. Figuren 3 und 4) des Trägers 10 eingesetzt werden kann.

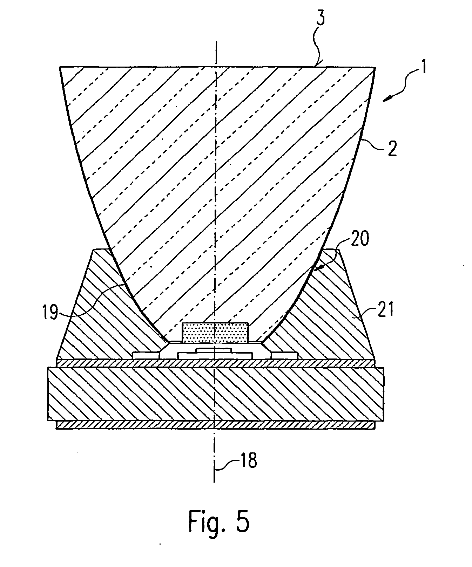

Fig. 5 zeigt eine Kegeloptik, bei der die Mantelfläche der Kegeloptik zumindest teilweise bspw. durch eine Außen aufgebrachte Metallschicht 19 verspiegelt ist. Diese Metallschicht stellt nur eine Möglichkeit dafür dar, wie ein Reflektor eine Totalreflektion ergänzen kann.

Durch das Vorsehen eines solchen Reflektors 19 zumindest in einem Teil der Kegeloptik kann in diesem Bereich auf die Wirkung der Totalreflektion sogar ganz verzichtet werden, so dass der LED-Strahler in diesem Bereich wie in Figur 5 gezeigt gefasst werden kann.

Bspw. kann der LED-Strahler in diesem Bereich der Mantelfläche der Kegeloptik mit einem Träger 21 verklebt werden.

Wie bereits erwähnt, kann die Erzeugung von weißem Licht ausgehend von blauen oder ultravioletten LEDs mittels eines Farbkonversionsprozesses von Luminophoren erzeugt werden, welche direkt über den LED-Chip angeordnet sind. Diese Luminophoren werden in einer transparenten, thermisch und lichtstabilen Matrix wie Epoxide, Acrylate oder Silikonen, eingebettet. Alternativ dazu kann die Farbkonversionsschicht auch direkt auf den LED-Chip aufgebracht werden. Die Befestigung der Kegeloptik auf den Substrat (Träger) kann entweder durch Verklebung oder durch Verschweißung sowie jegliche mechanische Befestigung erfolgen. Als Linsenmaterial werden bevorzugt hochtransparente Kunststoffe wie beispielsweise Polycarbonat, PMMA, PMMI, COC, COP oder aber auch Glas eingesetzt.

**Bezugszeichenliste:**

| | |
|---|---|
| 1: | trichterförmige Linse (Kegeloptik) |
| 2: | transparente Seitenwand |
| 3: | Austrittsfläche |
| 4: | direkter Lichtanteil |
| 5: | indirekter (totalreflektierter Lichtanteil) |
| 6: | Facette |
| 7: | Öffnung für LED-Die |
| 8: | LED-Die (LED-Chip) mit einer oder mehrerer LED |
| 9: | Farbkonversionmaterial |
| 10: | Träger |
| 11: | Befestigungsansatz ("Linsenbein") |
| 12: | Elektrische Kontaktierung |
| 13: | Leiterplatte |
| 14: | Vertiefung im Träger |
| 15, 16, 17: | Kreisbogenabschnitte |
| 18: | Symmetrieachse der Optik |
| 19: | Teilverspiegelung |
| 20: | Verklebung |
| 21: | Fassungsträger |

**Patentansprüche**

**1.** Weißlicht-LED-Strahler, aufweisend;

- eine Anordnung mit wenigstens einer farbigen LED, über der ein Farbkonversionsstoff angeordnet ist, der das Licht der LED konvertiert, und
- eine über dem Farbkonversionsstoff angeordnete Kegeloptik aus einem im Wesentlichen transparenten Vollmaterial,

wobei die LED-Anordnung bezüglich der Kegeloptik derart angeordnet ist, dass ein Teil des Lichts von der LED-Anordnung direkt auf die Mantelfläche der Kegeloptik trifft und von dort durch Totalreflexion in Richtung einer Austrittsfläche gelenkt wird, während ein anderer Teil des Lichts von der LED-Anordnung ohne Reflexion an der Mantelfläche der Kegeloptik direkt zu der Austrittsfläche gelangt, wobei an der Austrittsfläche Weißlicht durch Mischung des Lichts von der LED mit dem durch Farbkonversion erzeugten Licht austritt, **dadurch gekennzeichnet, dass** der Winkel, den die Mantelfläche mit der Symmetrieachse bildet, ein spitzer Winkel ist und mit zunehmendem Abstand von der LED-Anordnung flacher wird,

wobei die Basisfläche der Kegeloptik die Form eines Polygons aufweist,

wobei die Außenwand der Kegeloptik wenigstens in Teilbereichen planare Facetten aufweist, und

wobei die Außenwand der Kegeloptik drei Kreisbogenbereiche aufweist, die jeweils aus bezüglich der Symmetrieachse der Kegeloptik geneigten planaren Facetten bestehen,

wobei der dem Farbkonversionsstoff zugewandte Kreisbogen der planaren Facetten Lichtstrahlen von einer angenommenen Punktlichtquelle im Zentrum der LED-Chip-Oberfläche in einem Winkelbereich von 55°-75° bezüglich der Symmetrieachse der Kegeloptik zur Austrittsfläche derart totalreflektiert, dass sie eine Totalreflexion an der Innenseite der Kegeloptik von 5°-0° zur Symmetrieachse der Kegeloptik erfahren,

wobei sich an den ersten Kreisbogen der zweite Kreisbogen anschließt, welcher sich ausgehend vom ersten Kreisbogen von dem Farbkonversionsstoff weg erstreckt, wobei der zweite Kreisbogen Lichtstrahlen von der angenommenen Punktlichtquelle im Zentrum der LED-Chip-Oberfläche in einem Winkelbereich von 40-55° bezüglich der Symmetrieachse der Kegeloptik zur Austrittsfläche derart totalreflektiert, dass sie eine Totalreflexion an der Innenseite der Kegeloptik von 0°-5° zur Symmetrieachse der Kegeloptik erfahren,

wobei sich an den zweiten Kreisbogen der dritte Kreisbogen anschließt, welcher sich ausgehend vom zweiten Kreisbogen von dem Farbkonversionsstoff weg erstreckt, wobei der dritte Kreisbogen Lichtstrahlen von einer angenommenen Punktlichtquelle im Zentrum der LED-Chip-Oberfläche in einen Winkelbereich von 28-40° bezüglich der Symmetrieachse der Kegeloptik zur Austrittsfläche derart totalreflektiert, dass sie eine Totalreflexion an der Innenseite der Kegeloptik von 5°-0° zur Symmetrieachse der Kegeloptik erfahren, und

wobei Lichtstrahlen von einer angenommenen Punktlichtquelle im Zentrum der LED-Chip-Oberfläche in einen Winkelbereich von 0-28° bezüglich der Symmetrieachse der Kegeloptik ohne Reflexion an der Mantelfläche der Kegeloptik direkt zu der Austrittsfläche gelangen.

**2.** Weißlicht-LED-Strahler nach Anspruch 1,
**dadurch gekennzeichnet, dass**
das Farbkonversionsmaterial in Form eines Quaders oberhalb der LED-Anordnung vorgesehen ist.

**3.** Weißlicht-LED-Strahler nach einem der vorhergehenden Ansprüche,
**dadurch gekennzeichnet, dass**
die LED-Anordnung mehrere gleichfarbige LEDs aufweist.

**4.** Weißlicht-LED-Strahler nach einem der vorhergehenden Ansprüche,
**dadurch gekennzeichnet, dass**
die LED-Anordnung bündig in einen Träger eingesetzt ist, der die Basisfläche der Kegeloptik bildet.

**5.** Weißlicht-LED-Strahler, nach einem der vorhergehenden Ansprüche,
**dadurch gekennzeichnet, dass**
sich die Kegeloptik von der LED-Anordnung weg erweitert.

**6.** Weißlicht-LED-Strahler, nach einem der vorhergehenden Ansprüche,
**gekennzeichnet durch**
eine Kegeloptik aus einem im Wesentlichen transparenten Material, wobei die Mantelfläche der Kegeloptik in mehrere diskrete Bereiche unterteilt ist, die jeweils unterschiedliche Winkel zu der Symmetrieachse der Kegeloptik einschließen.

**Claims**

**1.** White LED spotlight, comprising:

- an arrangement with at least one coloured LED above which a colour conversion substance is disposed which converts the light of the LED, and
- a conical lens system produced from a substantially transparent solid material, which is disposed above the colour conversion substance,

wherein the LED arrangement is disposed such that a part of the light from the LED arrangement is directly incident on the shell of the conical lens system and is deviated from there by total reflection towards an exit surface, while another part of the light from the LED arrangement arrives directly at the exit surface without any reflection at the shell of the conical lens system, wherein through a mixture of light from the LED with the light generated by colour conversion white light is exiting the exit surface, **characterized in that**,
the angle formed by the shell and the axis of symmetry is an acute angle getting shallower with increasing distance from the LED arrangement,
wherein the base of the conical lens system has a polygonal shape,
wherein the outer wall of the conical lens system comprises planar facets at least in subareas, and
wherein the outer wall of conical lens system comprises three circular arc sections, each consisting of planar facets inclined with respect to the axis of symmetry of the conical lens system,
wherein the circular arc of the facets facing the colour conversion substance totally reflects light beams from an imaginary point light source in the centre of the LED chip surface within an angular range of 55° - 75° with respect to the axis of symmetry of the conical lens system to the exit surface such that they undergo a total reflection of 5° - 0° to the axis of symmetry of the conical lens system at the inner surface of the conical lens system,
wherein the second circular arc joins the first circular arc extending from the first circular arc away from the colour conversions substance, wherein the second circular arc totally reflects light beams from the imaginary point light source in the centre of the LED chip surface within an angular range of 44 - 55° with respect to the axis of
symmetry of the conical lens system to the exit surface such that they undergo a total reflection of 5° - 0° to the axis of symmetry of the conical lens system at the inner surface of the conical lens system,
wherein the third circular arc joins the second circular arc extending from the second circular arc away from the colour conversions substance, wherein the third circular arc totally reflects light beams from an imaginary point light source in the centre of the LED chip surface within an angular range of 28 - 40° with respect to the axis of symmetry of the conical lens system to the exit surface such that they undergo a total reflection of 5° - 0° to the axis of symmetry of the conical lens system at the inner surface of the conical lens system,
wherein light beams from an imaginary point light source in the centre of the LED chip surface arrive directly at the exit surface in an angular range of 0 - 28° with respect to the axis of symmetry without reflection at the shell of the conical lens system.

**2.** White LED spotlight according to claim 1,
**characterized in that**
the colour conversion substance is provided as a cuboid structure above the LED arrangement.

**3.** White LED spotlight according to any of the preceding claims,
**characterized in that**
the LED arrangement comprises several LEDs having the same colour.

**4.** White LED spotlight according to any of the preceding claims,
**characterized in that**
the LED arrangement is inserted flush with a carrier forming the base of the conical lens system.

5. White LED spotlight according to any of the preceding claims,
**characterized in that**
the conical lens system is expanding away from LED arrangement.

6. White LED spotlight according to any of the preceding claims,
**characterized by**
a conical lens system of a substantially transparent material, wherein the shell of the conical lens system is divided into plural discrete sections, each forming different angles with the axis of symmetry of the conical lens system.

**Revendications**

1. Spot à LED à lumière blanche, présentant :

- un arrangement avec au moins une LED de couleur, au-dessus de laquelle est disposée une substance de conversion de couleur, laquelle convertit la lumière de la LED, et
- une optique conique disposée au-dessus de la substance de conversion de couleur, l'optique conique étant réalisée en un matériau solide sensiblement transparent,

dans lequel l'arrangement à LED est disposé par rapport à l'optique conique de telle sorte qu'une partie de la lumière de l'arrangement à LED atteint directement la surface de l'enveloppe de l'optique conique et est dirigée à partir de là par réflexion totale en direction d'une surface de sortie, pendant qu'une autre partie de la lumière de l'arrangement à LED parvient directement à la surface de sortie sans réflexion sur la surface de l'enveloppe de l'optique conique, dans lequel de la lumière blanche sort de la surface de sortie par mélange de la lumière de la LED avec la lumière générée par conversion de couleur,
**caractérisé en ce que**
l'angle, que la surface de l'enveloppe forme avec l'axe de symétrie, est un angle aigu et devient plus plat à mesure que la distance par rapport à l'arrangement à LED devient plus grande, dans lequel la surface de base de l'optique conique présente la forme d'un polygone, dans lequel la paroi extérieure de l'optique conique présente des facette planes au moins dans des sous-parties, et dans lequel la paroi extérieure de l'optique conique présente trois domaines en arc de cercle, qui sont composés respectivement de facettes planes inclinées par rapport à l'axe de symétrie de l'optique conique, dans lequel l'arc de cercle des facettes planes orienté vers la substance de conversion de couleur réfléchit totalement des rayons lumineux d'une source de lumière ponctuelle supposée au centre de la surface de la puce à LED dans un domaine angulaire de 55° - 75° par rapport à l'axe de symétrie de l'optique conique vers la surface de sortie de telle sorte qu'ils subissent une réflexion totale sur le côté intérieur de l'optique conique de 5°-0° par rapport à l'axe de symétrie de l'optique conique, dans lequel le deuxième arc de cercle rejoint le premier arc de cercle, lequel deuxième arc de cercle s'étend à partir du premier arc de cercle en s'éloignant de la substance de conversion de couleur, le deuxième arc de cercle réfléchissant totalement des rayons lumineux de la source de lumière ponctuelle supposée au centre de la surface de la puce à LED dans un domaine angulaire de 40-55° par rapport à l'axe de symétrie de l'optique conique vers la surface de sortie de sorte qu'ils subissent une réflexion totale sur le côté intérieur de l'optique conique de 0°-5° par rapport à l'axe de symétrie de l'optique conique, dans lequel le troisième arc de cercle rejoint le deuxième arc de cercle, lequel troisième arc de cercle s'étend à partir du deuxième arc de cercle en s'éloignant de la substance de conversion de couleur, le troisième arc de cercle réfléchissant totalement des rayons lumineux d'une source de lumière ponctuelle supposée au centre de la surface de puce à LED dans un domaine angulaire de 28-40° par rapport à l'axe de symétrie de l'optique conique vers la surface de sortie de sorte qu'ils subissent une réflexion totale sur le côté intérieur de l'optique conique de 5°-0° par rapport à l'axe de symétrie de l'optique conique, et dans lequel des rayons lumineux d'une source de lumière ponctuelle supposée au centre de la surface de la puce à LED dans un domaine angulaire de 0-28° par rapport à l'axe de symétrie de l'optique conique parviennent directement à la surface de sortie sans réflexion sur la surface de l'enveloppe de l'optique conique.

2. Spot à LED à lumière blanche selon la revendication 1,
**caractérisé en ce que**
la substance de conversion de couleur est prévue sous la forme d'un parallélépipède rectangle au-dessus de l'arrangement à LED.

3. Spot à LED à lumière blanche selon l'une des revendications précédentes,
**caractérisé en ce que**
l'arrangement à LED présente plusieurs LEDs de même couleur.

**4.** Spot à LED à lumière blanche selon l'une des revendications précédentes,
**caractérisé en ce que**
l'arrangement à LED est monté à fleur dans un support, qui forme la surface de base de l'optique conique.

**5.** Spot à LED à lumière blanche selon l'une des revendications précédentes,
**caractérisé en ce que**
l'optique conique s'élargit avec une distance croissante par rapport à l'arrangement à LED.

**6.** Spot à LED à lumière blanche selon l'une des revendications précédentes,
**caractérisé par**
une optique conique réalisée en un matériau essentiellement transparent, la surface de l'enveloppe de l'optique conique étant subdivisée en plusieurs domaines discrets, qui contiennent respectivement des angles différents par rapport à l'axe de symétrie de l'optique conique.

EP 1 766 695 B1

Fig. 1

Fig. 2

9

Fig. 3

Fig. 4

Fig. 5

**EP 1 766 695 B1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- WO 0250472 A1
- EP 1418628 A1
- US 4143394 A
- US 1726379 A